# EUROPÄISCHE PATENTSCHRIFT

(11) **EP 0 910 109 B1**
(45) Veröffentlichungstag und Bekanntmachung des Hinweises auf die Patenterteilung: **15.09.2004**
(21) Anmeldenummer: 97116910.7
(22) Anmeldetag: 29.09.1997
(51) Int. Cl.: H01J 37/145

(54) **Objektivlinse**
Objective lens
Lentille objectif

(43) Veröffentlichungstag der Anmeldung: 21.04.1999
(73) Patentinhaber: ADVANTEST CORPORATION, Shinjuku-ku, Tokyo 163-08 (JP)
(72) Erfinder: Frosien,Jürgen,Dr., 85521 Riemerling (DE); Lanio,Stefan,Dr., 85435 Erding (DE); Schönecker,Gerald,Dr., 81549 München (DE)
(74) Vertreter: Tetzner, Volkmar, Dr.-Ing. Dr. jur.

(56) Entgegenhaltungen:
- EP-A- 0 790 634
- US-A- 5 606 261
- US-A- 5 644 132

## Beschreibung

Die Erfindung betrifft eine Objektivlinse zur Beeinflussung eines Korpuskularstrahls, insbesondere eines Elektronenstrahls, mit einer magnetischen Einzelpollinse und einer elektrostatischen Linse, die eine erste und eine zweite Elektrode aufweist, die mit unterschiedlichen Potentialen beaufschlagbar sind.

Derartige Objektivlinsen werden beispielsweise in der Elektronenstrahlmeßtechnik und anderen Anwendungsgebieten von Elektronenstrahlgeräten, wie Mikroskopie, Inspektion, Lithographie usw. eingesetzt. Die hochauflösenden Objektivlinsen sollen insbesondere im Niederspannungsbereich nur geringe Fehlerkoeffizienten aufweisen.

Aus der Praxis sind daher kombiniert elektrisch-magnetische Polschuh-Objektivlinsen bekannt, die geringe Fehlerkoeffizienten und dementsprechend gute Niederspannungseigenschaften aufweisen.

Eine Verbesserung dieser bekannten Objektivlinsen ist in der EP-A-0 790 634 offenbart, bei der die Magnetlinse durch eine Einzelpollinse gebildet wird, wobei innerhalb der Magnetlinse eine elektrostatische Bremslinse angeordnet ist.

Aus der US-A-5 644 132 und der US-A-5 606 261 sind Objektivlinsen bekannt, die Zweipollinsen aufweisen, die mit einer nachgeschalteten elektrostatischen Linse kombiniert sind.

Der Erfindung liegt nun die Aufgabe zugrunde, die bekannten Objektivlinsen dahingehend zu verbessern, daß noch niedrigere Aberrationskoeffizienten erzielt werden. Erfindungsgemäß wird diese Aufgabe durch das kennzeichnende Merkmal des Anspruches 1 gelöst, indem die elektrostatische Linse in Richtung des Korpuskularstrahls nach der magnetischen Einzelpollinse angeordnet ist.

Ferner sind die beiden Elektroden der elektrostatischen Linse als Rohrelektroden ausgebildet, wobei die erste Elektrode durch die Einzelpollinse hindurchgeführt ist und die zweite Elektrode koaxial zur ersten Elektrode angeordnet ist.

Weitere Ausgestaltungen der Erfindung sind Gegenstand der Unteransprüche.

Durch eine geschlitzte Ausbildung einer der beiden Elektroden lassen sich auf einfache Weise elektrische Multipolelemente bilden, die beispielsweise als elektrostatische Ablenker, Stigmatoren oder andere Korrekturelemente geschaltet und verwendet werden können.

Weitere Ausgestaltungen und Vorteile der Erfindung werden anhand einiger Ausführungsbeispiele und der Zeichnung näher erläutert.

In der Zeichnung zeigen
- Fig.1: eine schematische Darstellung der Objektivlinse gemäß einem ersten Ausführungsbeispiel,
- Fig.2a: eine schematische Darstellung der Objektivlinse gemäß einem zweiten Ausführungsbeispiel,
- Fig.2b: eine schematische Darstellung der Objektivlinse gemäß einem dritten Ausführungsbeispiel,
- Fig.3a, 3b: schematische Darstellungen der elektrostatischen Linse in zwei unterschiedlichen Einstellungen,
- Fig.4: eine schematische Darstellung der elektrostatischen Linse gemäß einem zweiten Ausführungsbeispiel,
- Fig.5: eine schematische Darstellung der elektrostatischen Linse gemäß einem dritten Ausführungsbeispiel,
- Fig.6a: eine schematische Darstellung der elektrostatischen Linse mit geschlitzter Elektrode zur Bildung von elektrischen Multipolelementen,
- Fig.6b: eine Unteransicht der elektrostatischen Linse gemäß Fig.6a,
- Fig.7a: eine schematische Darstellung einer elektrostatischen Linse mit elektrischen und magnetischen Multipolen gemäß einem ersten Ausführungsbeispiel,
- Fig.7b: eine Unteransicht der elektrostatischen Linse gemäß Fig.7a,
- Fig.8a: eine schematische Darstellung einer elektrostatischen Linse mit elektrischen und magnetischen Multipolen gemäß einem zweiten Ausführungsbeispiel,
- Fig.8b: eine Unteransicht der elektrostatischen Linse gemäß Fig.8a und
- Fig.9: eine schematische Darstellung eines Korpuskularstrahlgerätes.

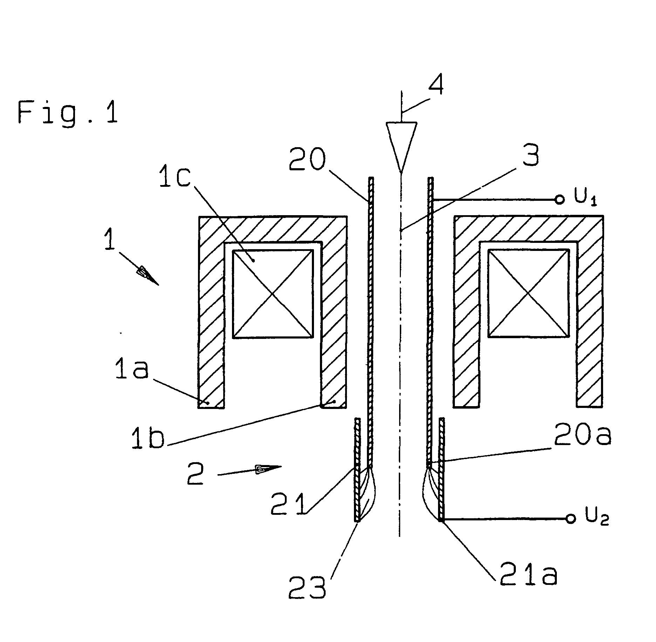

Die in Fig.1 dargestellte Objektivlinse zur Beeinflussung eines Korpuskularstrahls, insbesondere eines Elektronenstrahls, besteht aus einer magnetischen Einzelpollinse 1 und einer elektrostatischen Linse 2, die eine erste Elektrode 20 und eine zweite Elektrode 21 aufweist, die mit unterschiedlichen Potentialen beaufschlagbar sind. Die Magnetlinse 1 weist einen ersten und einen zweiten Polschuh 1a, 1b und eine Erregerspule 1c auf.

Die beiden Elektroden 20, 21 sind als Rohrelektroden ausgebildet, wobei die erste Elektrode 20 durch die Einzelpollinse 1 hindurchgeführt ist und mit ihrem unteren Ende 20a aus der Einzelpollinse 1 herausragt.

Die zweite Elektrode 21 ist koaxial zur ersten Elektrode 20 derart angeordnet, daß sie die erste Elektrode 20 teilweise überlappt und im Durchmesser größer ausgebildet ist. Die elektrostatische Linse 2 bildet ein Linsenfeld 23, das sich im Bereich des unteren Endes 20a der ersten Elektrode 20 und der angrenzenden inneren Wandung der zweiten Elektrode 21 ausbreitet.

Die Objektivlinse weist eine optische Achse 3 auf, um die die Einzelpollinse 1 und die elektrostatische Linse 2 rotationssymmetrisch angeordnet sind. Mit einem Pfeil 4 ist ein Korpuskularstrahl angedeutet.

Die dargestellte Objektivlinse zeichnet sich dadurch aus, daß die elektrostatische Linse 2 in Richtung des Korpuskularstrahls 4 nach der magnetischen Einzelpollinse 1 angeordnet ist. Nachdem sich das magnetische Feld unterhalb der Einzelpollinse 1 ausbildet und sich das elektrische Feld ebenfalls unterhalb der Einzelpollinse ausbreitet, liegt das elektrische Feld entweder im oder unterhalb des magnetischen Feldes.

Die elektrostatische Linse 2 wird vorzugsweise als Bremslinse hinsichtlich des Korpuskularstrahls 4 betrieben.

Zum Aufbau der Bremswirkung auf den Korpuskularstrahl 4 wird die erste Elektrode 20 mit einer ersten Spannung U₁ und die zweite Elektrode 21 mit einer zweiten Spannung U₂ beaufschlagt, wobei die erste Spannung beispielsweise 2 kV und die zweite Spannung zwischen 0 und +/- 100 V beträgt, aber auch höhere Spannungen möglich sind.

Das elektrische Bremsfeld wirkt auf den primären Korpuskularstrahl somit erst ein, wenn dieser durch das Magnetfeld fokusiert worden ist. Dadurch können die durch die elektrostatische Linse nicht vermeidbaren Fehlerkoeffizienten verhältisnimäßig gering gehalten werden.

Die in Fig.2a dargestellte Objektivlinse weist eine konisch ausgebildete Einzelpollinse 1' auf, die mit einer elektrostatischen Linse 2' kombiniert ist.

Eine derartige Objektivlinse eignet sich insbesondere in Korpuskularstrahlgeräten mit einem großen kippbaren Probentisch, da durch die konische Ausbildung der Einzelpollinse weiterer Platz für die Kippung der Probe gewonnen wird.

Die elektrostatische Linse 2' unterscheidet sich von der Ausführung gemäß Fig.1 dadurch, daß die zweite Elektrode 21' im Durchmesser kleiner als die erste Elektrode 20 ausgebildet ist und von unten in die erste Elektrode 20 hineinragt. Das Linsenfeld 23' bildet sich hier zwischen dem hineinragenden Ende der zweiten Elektrode 21' und der angrenzenden Wandung der ersten Elektrode 20 aus.

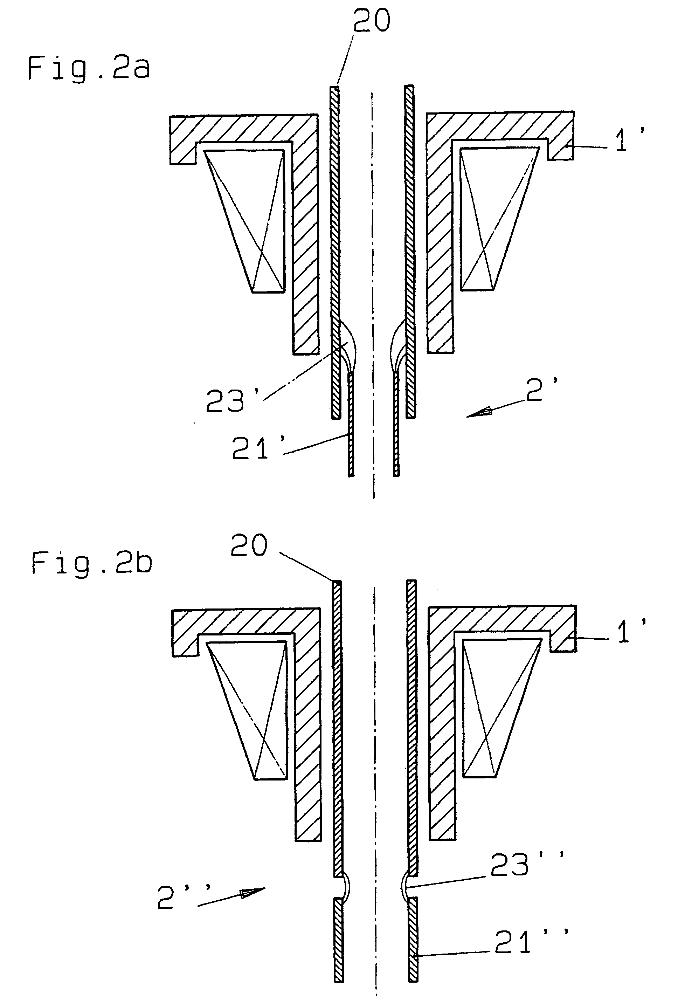

In Fig.2b ist schließlich eine dritte Variante einer elektrostatischen Linse 2'' dargestellt, bei der sowohl die erste Elektrode 20 als auch die zweite Elektrode 21'' gleichen Durchmesser haben und mit Abstand voneinander angeordnet sind. Das sich ausbildende Linsenfeld 23'' ist bei dieser Anordnung im Übergangsbereich zwischen der ersten und zweiten Elektrode vorgesehen.

Zur Beeinflussung der elektrostatischen Linseneigenschaften können die beiden Elektroden 20, 21 bzw. 21' und 21'' der elektrostatischen Linse 2 bzw. 2', 2'' relativ zueinander in Richtung der optischen Achse verschiebbar angeordnet werden. Dadurch läßt sich beispielsweise im Ausführungsbeispiel gemäß Fig.1 der Abstand in Richtung der optischen Achse 3 zwischen dem unteren Ende 20a und dem unteren Ende 21a der beiden Elektroden verändern, wodurch nicht zuletzt auch die elektrische Feldstärke am Ort einer Probe eingestellt werden kann.

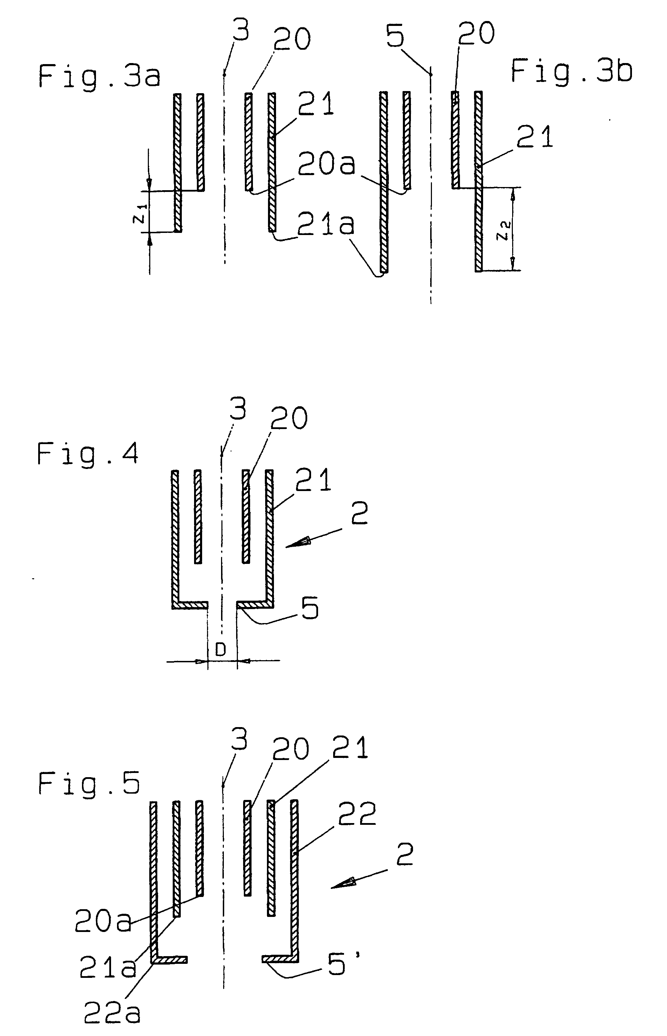

Im dargestellten Ausführungsbeispiel der Fig.3a und 3b sind die beiden Elektroden 20, 21 mit unterschiedlichen Abständen z₁ bzw. z₂ dargestellt. Die erste Elektrode 20 taucht in Fig.3a wesentlich weiter in die zweite Elektrode 21 ein als das bei dem Ausführungsbeispiel gemäß Fig.3b der Fall ist.

Eine weitere Möglichkeit zur Beeinflussung der elektrostatischen Linseneigenschaften ist in Fig.4 gezeigt, bei der die zweite Elektrode 21 mit einer Blende 5 versehen ist. Mit unterschiedlichen Öffnungsdurchmessern D der Blende 5 kann die elektrostatische Linse an die jeweiligen Bedürfnisse angepaßt werden.

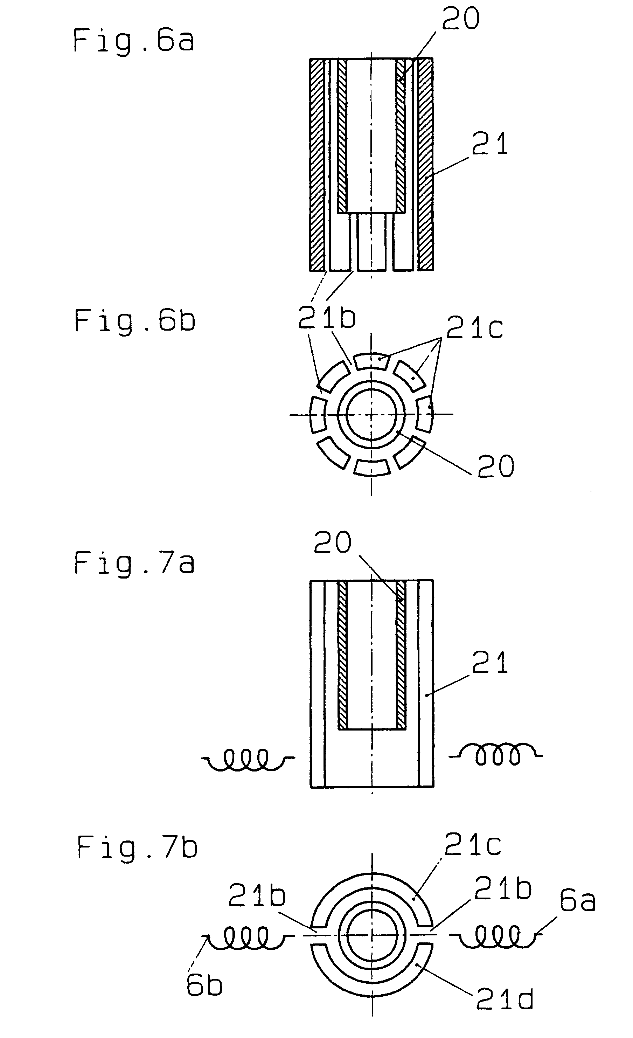

Die elektrostatische Linse 2 kann neben den beiden Elektroden 20, 21 auch eine weitere, dritte Elektrode 22 aufweisen, die wiederum als Rohrelektrode ausgebildet ist. Im Ausführungsbeispiel gemäß Fig.5 ist die dritte Elektrode 22 koaxial um die zweite Elektrode 21 angeordnet, wobei deren unteres Ende 22a in Richtung der optischen Achse 3 einen Abstand vom unteren Ende 21a der zweiten Elektrode aufweist. Die dritte Elektrode 22 ist hier ferner mit einer Blende 5' versehen.

Eine weitere Ausführungsform sieht die Schlitzung einer der beiden Elektroden in Multipolelemente vor. In dem in Fig.6a dargestellten Ausführungsbeispiel ist die Elektrode 21 mit Schlitzen 21b versehen. Zwischen den Schlitzen 21 bilden sich im dargestellten Ausführungsbeispiel acht elektrische Multipolelemente 21c. Durch geeignetes Anlegen von Spannungen können diese elektrisehen Multipolelemente 21c als elektrostatische Ablenker, Stigmatoren oder andere Korrekturelemente geschaltet und verwendet werden. Die einzelnen Spannungen werden dabei so gewählt, daß sich wiederum eine mittlere Spannung ergibt, die der Spannung U₂ entspricht.

In dem in den Fig.7a, 7b gezeigten Ausführungsbeispiel ist die Elektrode 21 mit zwei Schlitzen 21b versehen, so daß zwei elektrische Multipolelemente 21c, 21d gebildet werden. Außerhalb der Elektrode 21 sind im Bereich der Schlitze 21b ferner jeweils ein magnetisches Multipolelement 6a, 6b angeordnet, die durch eine geeignete Anordnung von Spulen oder Permanentmagneten gebildet werden.

Mit einer derartigen Anordnung können gekreuzte, elektrisch/magnetische Dipol-Transversalfelder (Wienfilter) erzeugt werden. Diese können derart abgestimmt werden, daß der primäre Korpuskularstrahl 4 nicht beeinflußt wird, etwaige an einer Probe ausgelöste Sekundär- und Rückstreuelektronen hingegen abgelenkt und einem außeraxialen in-lens- oder pre-lens-Detektor zugeführt werden, der beide Signale gemeinsam oder durch geeigneten Aufbau getrennt nachweisen kann.

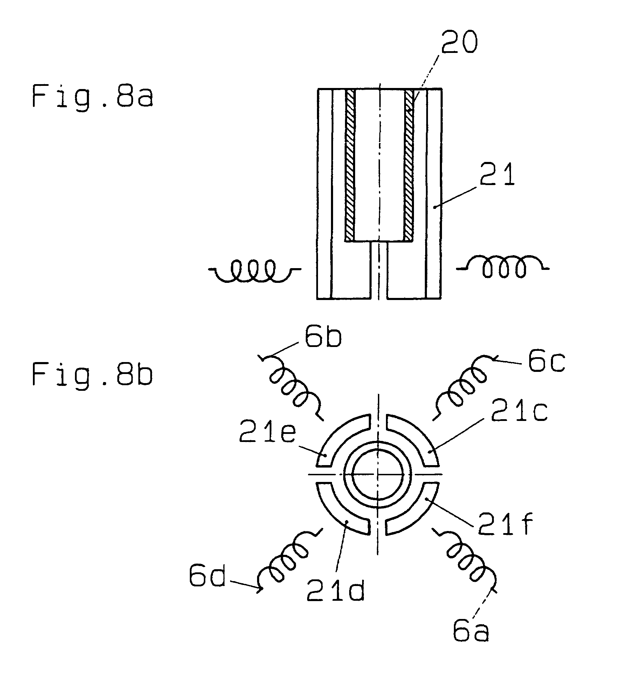

Im Ausführungsbeispiel gemäß den Fig.8a, 8b sind jeweils vier elektrische Multipolelemente 21c, 21d, 21e, 21f und vier magnetische Multipolelemente 6a, 6b, 6c, 6d vorgesehen, die gekreuzte, elektrisch/magnetische Quadrupol-Transversalfelder erzeugen können. Diese können derart abgestimmt werden, daß der primäre Korpuskularstrahl nicht beeinflußt wird, die Sekundär- und Rückstreuelektronen hingegen aufgespalten und zwei außeraxialen in-lens- oder pre-lens-Detektoren zugeführt werden können, die beide Signale gemeinsam oder durch geeigneten Aufbau getrennt nachweisen können. Im Rahmen der Erfindung können auch elektrisch/magnetische Multipolfelder höherer Ordnung angewendet werden.

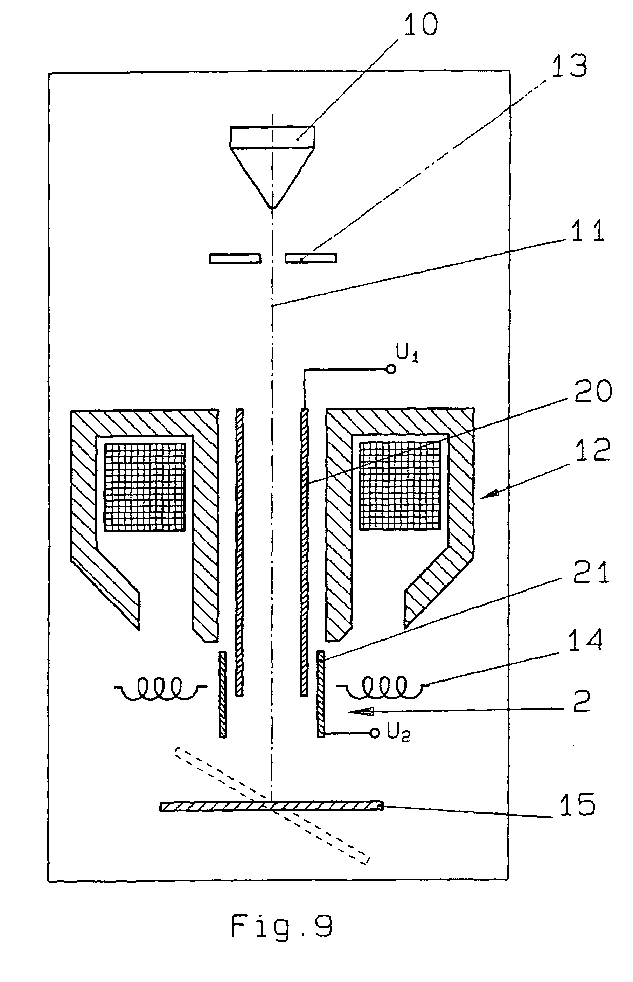

Die oben beschriebene, hochauflösende Objektivlinse zeichnet sich durch geringe Aberrationskoeffizienten insbesondere im Niederspannungsbereich aus. Sie kann daher insbesondere vorteilhaft in einem Elektronenstrahlgerät eingesetzt werden, wie es beispielhaft in Fig.9 dargestellt ist. Es besteht im wesentlichen aus einer Quelle 10 zur Erzeugung eines Elektronenstrahls und einer Objektivlinse 12. Neben weiteren nicht näher dargestellten Blenden und Aperturen ist insbesondere noch eine Austasteinrichtung 13 vorgesehen.

Die Objektivlinse 12 kann wahlweise entsprechend den Fig.1 bis 8b ausgestaltet sein. Im Bereich der elektrostatischen Linse 2 ist im dargestellten Beispiel ferner eine Ablenkeinrichtung 14 vorgesehen, um den Elektronenstrahl 11 auf einer Probe 15 auszulenken.

Durch Zwischenschaltung eines Sekundärelektronen-Spektrometers kann die Objektivlinse vorteilhaft auch in der Elektronenstrahlmeßtechnik bzw. beim Elektronenstrahltesten verwendet werden.

Die elektrostatische Linse 2 kann durch die Ausbildung der Elektroden als Rohrelektroden auch als Schnorchellinse bezeichnet werden, deren geringer Durchmesser gerade in Probennähe viel Platz bietet, der zur Anbringung von Detektoren und anderen Einrichtungen sowie zur Probenkippung genutzt werden kann.

Die elektrische Feldstärke am Ort der Probe, die auch zur Absaugung von Sekundärelektronen und für den Transfer zu einem in-lens- oder pre-lens-Detektor benutzt werden kann, kann entweder durch die unterschiedliche Eintauchtiefe der ersten Elektrode 20 in die zweite Elektrode 21 oder durch eine Blende in passender Größe am unteren Ende der zweiten Elektrode 21 den Bedürfnissen entsprechend eingestellt werden.

Die geschlitzte Ausführung der Elektrode 21 gemäß den Fig.6a bis 8b bietet die Möglichkeit, daß Strahlbeeinflussungselemente zur Ablenkung bzw. Korrektur des Primärelektronenstrahls bzw. zur Beeinflussung der Sekundärelektronen leicht und äußerst platzsparend miteinander kombiniert werden können, da dies nur einer Addition geeigneter Spannungen auf den Multipolelementen bzw. -elektroden bedarf. Hierdurch können sehr bequem Multifunktionalelemente in die Objektivlinse integriert werden, was bei konventionellen Anordnungen mangels Platz meist nicht möglich war.

## Patentansprüche

1. Objektivlinse zur Beeinflussung eines Korpuskularstrahls mit einer magnetischen Einzelpollinse (1; 1') und einer elektrostatischen Linse (2), die eine erste und eine zweite Elektrode (20, 21) aufweist, die mit unterschiedlichen Potentialen beaufschlagbar sind,
**dadurch gekennzeichnet, daß** die erste und die zweite Elektrode (20, 21) als Rohrelektroden ausgebildet sind,
die erste Elektrode (20) durch die Einzelpollinse (1; 1') hindurchgeführt ist und die zweite Elektrode (21) koaxial zur ersten Elektrode angeordnet ist und wobei ferner
die elektrostatische Linse (2) in Richtung des Korpuskularstrahls (4) nach der magnetischen Einzelpollinse (1; 1') angeordnet ist.

2. Objektivlinse nach Anspruch 1, **dadurch gekennzeichnet, daß** die erste Elektrode (20) als Rohrelektrode ausgebildet ist, die durch die Einzelpollinse (1) hindurchgeführt ist und mit ihrem unteren Ende (20a) aus der Einzelpollinse (1; 1') herausragt.

3. Objektivlinse nach Anspruch 1, **dadurch gekennzeichnet, daß** die Objektivlinse eine optische Achse (3) aufweist, um die die Einzelpollinse (1; 1') und die beiden Elektroden (20, 21) rotationssymmetrisch angeordnet sind, wobei die beiden Elektroden (20, 21) - in Richtung der optischen Achse (3) - relativ zueinander verschiebbar sind.

4. Objektivlinse nach Anspruch 1, **dadurch gekennzeichnet, daß** die zweite Elektrode (21) an ihrem von der Einzelpollinse (1; 1') entfernten Ende (21a) eine Blende (5; 5') aufweist.

5. Objektivlinse nach Anspruch 1, **dadurch gekennzeichnet, daß** eine der beiden Elektroden zur Bildung von elektrischen Multipolelementen (21c - 21f) geschlitzt ausgebildet ist.

6. Objektivlinse nach Anspruch 5, **dadurch gekennzeichnet, daß** der geschlitzte Teil der Elektrode (21) als elektrostatischer Ablenker ausgebildet ist.

7. Objektivlinse nach Anspruch 5, **dadurch gekennzeichnet, daß** der geschlitzte Teil der Elektrode (21) als Stigmator ausgebildet ist.

8. Objektivlinse nach Anspruch 5, **dadurch gekennzeichnet, daß** den elektrischen Multipolen (21c - 21f) magnetische Multipole (6a - 6d) überlagert sind.

9. Objektivlinse nach Anspruch 1, **dadurch gekennzeichnet, daß** die elektrostatische Linse (2) bezüglich des Korpuskularstrahls als Bremslinse wirkt.

10. Objektivlinse nach Anspruch 8, **dadurch gekennzeichnet, daß** jeweils zwei elektrische und magnetische Multipole (21c, 21d, 6a, 6b) derart angeordnet sind, daß sie gekreuzte, elektrisch/magnetische Dipol-Transversalfelder bilden.

11. Objektivlinse nach Anspruch 8, **dadurch gekennzeichnet, daß** jeweils vier elektrische und magnetische Multipole (21c, 21d, 21e, 21f, 6a, 6b, 6c, 6d) derart angeordnet sind, daß sie gekreuzte, elektrisch/magnetische Quadrupol-Transversalfelder bilden.

## Claims

1. Objective lens for influencing a particle beam and having a magnetic single-pole lens (1; 1') and an electrostatic lens (2) which has a first electrode (20) and a second electrode (21) which can be subjected to different potentials, **characterised in that** the first electrode (20) and the second electrode (21) are constructed as tubular electrodes, **in that** the first electrode (20) is guided through the single-pole lens (1; 1') and the second electrode (21) is arranged coaxially with the first electrode, and the electrostatic lens (2) further being arranged in the direction of the particle beam (4) downstream of the magnetic single-pole lens (1; 1').

2. Objective lens according to claim 1, **characterised in that** the first electrode (20) is constructed as a tubular electrode which is guided through the single-pole lens (1) and which protrudes from the single-pole lens (1; 1') at the lower end (20a) thereof.

3. Objective lens according to claim 1, **characterised in that** the objective lens has an optical axis (3), about which the single-pole lens (1; 1') and the two electrodes (20, 21) are arranged in a rotationally symmetrical manner, the two electrodes (20, 21) being able to be displaced relative to each other in the direction of the optical axis (3).

4. Objective lens according to claim 1, **characterised in that** the second electrode (21) has a screen (5; 5') at the end (21a) thereof that is remote from the single-pole lens (1; 1').

5. Objective lens according to claim 1, **characterised in that** one of the two electrodes is constructed in a slotted manner in order to form electrical multiple-pole elements (21c - 21f).

6. Objective lens according to claim 5, **characterised in that** the slotted portion of the electrode (21) is constructed as an electrostatic deflector.

7. Objective lens according to claim 5, **characterised in that** the slotted portion of the electrode (21) is constructed as a stigmator.

8. Objective lens according to claim 5, **characterised in that** magnetic multiple-poles (6a - 6d) are arranged above the electrical multiple-poles (21c - 21f).

9. Objective lens according to claim 1, **characterised in that** the electrostatic lens (2) acts as a retarding lens relative to the particle beam.

10. Objective lens according to claim 8, **characterised in that** two electrical and magnetic multiple-poles (21c, 21d, 6a, 6b) are arranged in each case in such a manner that they form crossed, electrical/magnetic dipolar transverse fields.

11. Objective lens according to claim 8, **characterised in that** four electrical and magnetic multiple poles (21c, 21d, 21e, 21f, 6a, 6b, 6c, 6d) are arranged in each case in such a manner that they form crossed, electrical/magnetic quadrupole transverse fields.

## Revendications

1. Lentille d'objectif destinée à agir sur un faisceau de corpuscules, qui présente une lentille magnétique unipolaire (1 ; 1') et une lentille électrostatique (2) qui présente une première et une deuxième électrodes (20, 21) sur lesquelles on peut appliquer des potentiels électriques différents, **caractérisée en ce que** la première et la deuxième électrodes (20, 21) sont configurées comme électrodes tubulaires, la première électrode (20) est passée à travers la lentille unipolaire (1 ; 1') et la deuxième électrode (21) est coaxiale à la première électrode, et dans laquelle, de plus, la lentille électrostatique (2) est disposée dans la direction du faisceau de corpuscules (4) après la lentille magnétique unipolaire (1 ; 1').

2. Lentille d'objectif selon la revendication 1, **caractérisée en ce que** la première électrode (20) est configurée comme électrode tubulaire qui est passée à travers la lentille unipolaire (1) et qui déborde par son extrémité inférieure (20a) hors de la lentille unipolaire (1 ; 1').

3. Lentille d'objectif selon la revendication 1, **caractérisée en ce que** la lentille d'objectif présente un axe optique autour duquel la lentille unipolaire(1 ; 1') et les deux électrodes (20, 21) sont disposées à symétrie de rotation, les deux électrodes (20, 21) pouvant être déplacées l'une par rapport à l'autre dans la direction de l'axe optique (3).

4. Lentille d'objectif selon la revendication 1, **caractérisée en ce que** la deuxième électrode (21) présente à son extrémité (21a) éloignée de la lentille unipolaire (1 ; 1') un obturateur (5 ; 5').

5. Lentille d'objectif selon la revendication 1, **caractérisée en ce que** l'une des deux électrodes a une configuration fendue pour former des éléments électriques multipolaires (21c - 21f).

6. Lentille d'objectif selon la revendication 5, **caractérisée en ce que** la partie fendue de l'électrode (21) est configurée comme déviateur électrostatique.

7. Lentille d'objectif selon la revendication 5, **caractérisée en ce que** la partie fendue de l'électrode (21) est configurée comme stigmateur.

8. Lentille d'objectif selon la revendication 5, **caractérisée en ce que** des multipôles magnétiques (6a - 6d) sont superposés aux multipôles électriques (21c - 21f).

9. Lentille d'objectif selon la revendication 1, **caractérisée en ce que** la lentille électrostatique (2) agit comme lentille de freinage du faisceau de corpuscules.

10. Lentille d'objectif selon la revendication 8, **caractérisée en ce que** des multipôles électriques et des multipôles magnétiques (21c, 21d, 6a, 6b) sont disposés de manière à former des champs transversaux électriques/magnétiques dipolaires croisés.

11. Lentille d'objectif selon la revendication 8, **caractérisée en ce que** quatre multipôles électriques et quatre multipôles magnétiques (21c, 21d, 21e, 21f, 6a, 6b, 6c, 6d) sont disposés de manière à former des champs transversaux électriques/magnétiques quadripolaires croisés.
